# EUROPEAN PATENT SPECIFICATION

(11) **EP 1 734 538 B1**
(45) Date of publication and mention of the grant of the patent: **29.06.2011**
(21) Application number: 06007987.8
(22) Date of filing: 18.04.2006
(51) Int. Cl.: G21K 4/00, C09K 11/61

(54) **Method for producing phosphor panels**
Herstellungsverfahren für Leuchtschirme
Procédé de fabrication de panneaux phosphorescents

(30) Priority: 19.04.2005 JP 2005121070
(43) Date of publication of application: 20.12.2006
(73) Proprietor: FUJIFILM Corporation, Minato-ku Tokyo (JP)
(72) Inventor: Hasegawa, Ken c/o Fuji Photo Film Co.,Ltd., Ashigara-kami-gun, Kanagawa (JP)
(74) Representative: Klunker . Schmitt-Nilson . Hirsch

(56) References cited:
- JP-A- 3 028 800
- JP-A- 2004 077 236
- US-A1- 2003 113 580

## Description

The present invention relates to a method for producing a phosphor panel, and more specifically a method for producing phosphor panels including a step of polishing the surface of a phosphor layer.

Upon exposure to a radiation (e.g. X-rays, α-rays, β-rays, γ-rays, electron beams, and ultraviolet rays), certain types of phosphors known in the art accumulate part of the energy of the applied radiation and, in response to subsequent application of excitation light such as visible light, they emit photostimulated luminescence in an amount that is associated with the accumulated energy. Called "storage phosphors" or "stimulable phosphors", those types of phosphors find use in medical and various other fields.

A known example of such use is a radiation image information recording and reproducing system that employs a stimulable phosphor panel having a film (or layer) of the stimulable phosphor (which is hereinafter referred to as a phosphor layer). The stimulable phosphor panel is hereinafter referred to simply as the phosphor panel and is also called the radiation image conversion sheet. The system has already been commercialized by, for example, Fuji Photo Film Co., Ltd. under the trade name of FCR (Fuji Computed Radiography).

In that system, a subject such as a human body is irradiated with X-rays or the like to record radiation image information about the subject on the phosphor panel (more specifically, the phosphor layer). After the radiation image information is thus recorded, the phosphor panel is scanned two-dimensionally with excitation light such as laser light to emit photostimulated luminescence which, in turn, is read photoelectrically to yield an image signal. Then, an image reproduced on the basis of the image signal is output as the radiation image of the subject, typically to a display device such as CRT or on a recording material such as a photosensitive material.

The phosphor panel is typically prepared by the following method: Powder of a stimulable phosphor is dispersed in a solvent containing a binder and other necessary ingredients to make a coating solution, which is applied to a panel-shaped support made of glass or a resin, with the applied coating being subsequently dried.

Also known are phosphor panels which are prepared by forming a phosphor layer on a support through vacuum film deposition (vapor-phase film deposition) such as vacuum deposition or sputtering. The phosphor layer formed by the vacuum film deposition has superior characteristics in that it is formed in vacuo and hence has low impurity levels and that being substantially free of any ingredients other than the stimulable phosphor as exemplified by a binder, the phosphor layer has not only small scatter in performance but also features very highly efficient luminescence.

One factor that deteriorates the characteristics of the phosphor panel having the phosphor layer formed by vacuum film deposition is that fine irregularities (hillocks) occur on the surface of the phosphor layer.

The phosphor layer and in particular the layer made of an alkali halide-based phosphor and having excellent characteristics has a columnar crystal structure, but local abnormal growth of columnar crystals and fusion of adjacent columnar crystals are observed in the process of their growth, which causes hillocks on the surface of the phosphor layer. The hillocks can be visually identified on a radiation image as point defects and as a result, may be detrimental to various diagnoses and tests.

Moisture absorption in the phosphor layer is another factor that deteriorates the characteristics of the phosphor panel.

The phosphor layer and in particular the layer made of an alkali halide-based stimulable phosphor and having excellent characteristics is highly hygroscopic and readily absorbs moisture even in a normal temperature and humidity environment. As a result, deterioration of the photostimulated luminescence characteristics, that is, sensitivity and deterioration of the crystallinity of the stimulable phosphor (for example, the crystal columnarity is impaired in an alkali halide-based stimulable phosphor having a columnar structure) may reduce the sharpness of a reproduced image.

In order to obviate such an inconvenience, it is known to use a moisture-proof transparent sheet in the phosphor panel as the moisture-proof protective layer to seal the phosphor layer in an enclosed region between the moisture-proof protective layer and the substrate.

If the hillocks occurring on the surface of the phosphor layer have a certain height, the moisture-proof protective layer may catch on the hillocks during the formation of the moisture-proof protective layer on the phosphor layer, and the moisture-proof protective layer assumes a tent-like shape, whereby the defective area is enlarged in the produced phosphor panel.

In order to solve such a problem, it is known to polish the surface of the phosphor layer to make it uniform.

For example, according to the phosphor panel disclosed in JP 3398406 B, a continuous film is formed on the surface of a phosphor layer composed of columnar crystals or mechanical treatment is carried out thereon to flatten the phosphor layer surface and its surface roughness or the flatness in the surface portions of the columnar crystals is defined to form the phosphor layer having a more uniform thickness profile.

According to the phosphor panel disclosed in JP 2004-77236 A, the thickness of a phosphor layer is made uniform by moving a polishing member and a substrate relative to each other with the polishing member placed at a predetermined distance from the polishing reference plane on the surface of the phosphor layer.

### SUMMARY OF THE INVENTION

However, the conventional methods of polishing the surface of the phosphor layer as described in these publications cannot effectively remove the hillocks and still cause image defects resulting therefrom.

Flaws develop on the surface of the phosphor layer depending on the polishing method, which may lead to deterioration in image quality.

The present invention has been accomplished in order to solve the aforementioned problems and it has an object of providing a method for producing a phosphor panel in which hillocks on a phosphor layer can be effectively removed by polishing its surface without causing deterioration of image quality or other defects resulting therefrom.

This object is achieved by the features of claim 1. Preferred embodiments are defined by the dependent claims.

The present invention provides a method for producing a phosphor panel in which hillocks on a phosphor layer can be removed positively with an extremely high efficiency while preventing the occurrence of image quality deterioration due to surface polishing.

Preferred embodiments are defined by the dependent claims.

In the present invention, it is preferred that the method for producing a phosphor panel further comprises the steps of:
estimating a thickness profile of the phosphor layer; wherein the surface of the phosphor layer is polished by means of the polishing member as it is pressed with a pressing member that extends in a one-dimensional direction in such a way that a direction in which the thickness profile of the phosphor layer is more uniform coincides with the one-dimensional direction in which the pressing member extends, and the phosphor layer and the polishing member being moved relative to each other at the distance of from 50 µm to 400 µm in a direction perpendicular to the one-dimensional direction in which the pressing member extends.

In the present invention, the phosphor layer whose surface has been polished is preferably sealed with a moisture-proof protective layer.

In the present invention, the phosphor layer is preferably formed of a stimulable phosphor.

In the present invention, the phosphor layer is preferably formed of CsBr:Eu.

According to the inventive method for producing phosphor panels, the hillocks occurring on the surface of the phosphor layer are polished as much as possible so that there is little likelihood for image quality deterioration to occur from hillocks and, in addition, even when the phosphor layer is laminated with a moisture-proof protective layer, there is also little likelihood for the protective layer to be stretched by an underlying hillock to assume a tent-like shape, resulting in an enlarged defective area. Since these possibilities are minimized, the present invention enables the production of a high-quality phosphor panel capable of generating a very sharp radiation image.

Preferably, a thickness profile of the phosphor layer is estimated and the surface of the phosphor layer is polished by means of a polishing member as it is pressed with a pressing member that extends in a one-dimensional direction in such a way that the direction in which the thickness profile of the phosphor layer is more uniform coincides with the direction in which the pressing member extends (namely, as the pressing member holds down the polishing member while it traces the surface waviness of the phosphor layer), with the phosphor layer and the polishing member being moved relative to each other in a direction perpendicular to the direction in which the pressing member extends. As a result, hillocks on the phosphor layer can be effectively polished away. At the same time, the chance of polishing away any other portions than the hillocks is sufficiently decreased to reduce the amount by which the phosphor layer needs to be polished; further in addition, this will reduce the chance for the polishing debris to get stuck between adjacent columnar crystals in the phosphor layer, thereby lowering the chance of deterioration in the quality of the radiation image to be formed on the phosphor panel.

According to the method of the present invention for producing a phosphor panel, the surface of the phosphor layer is polished repeatedly by means of a polishing member in changed polishing positions on the phosphor layer as the phosphor layer and the polishing member are moved relative to each other at a distance of from 50 µm to 400 µm, preferably between 100 µm and 300 µm. As a consequence, the length of flaws that occur on the surface of the phosphor layer as a result of its polishing is reduced to sufficiently small values for the sharpness of the radiation image formed on the phosphor panel not to be substantially affected. Consequently, phosphor panels capable of producing sharper radiation image can be provided in a consistent manner.

### BRIEF DESCRIPTION OF THE DRAWINGS

FIG. 1 is a cross sectional view showing an embodiment of a phosphor panel according to the present invention;
FIG. 2 is a view illustrating an example of a step of polishing a phosphor layer according to the present invention; and
FIG. 3 is a view illustrating another example of the step of polishing the phosphor layer according to the present invention.

### DETAILED DESCRIPTION OF THE PREFERRED EMBODIMENTS

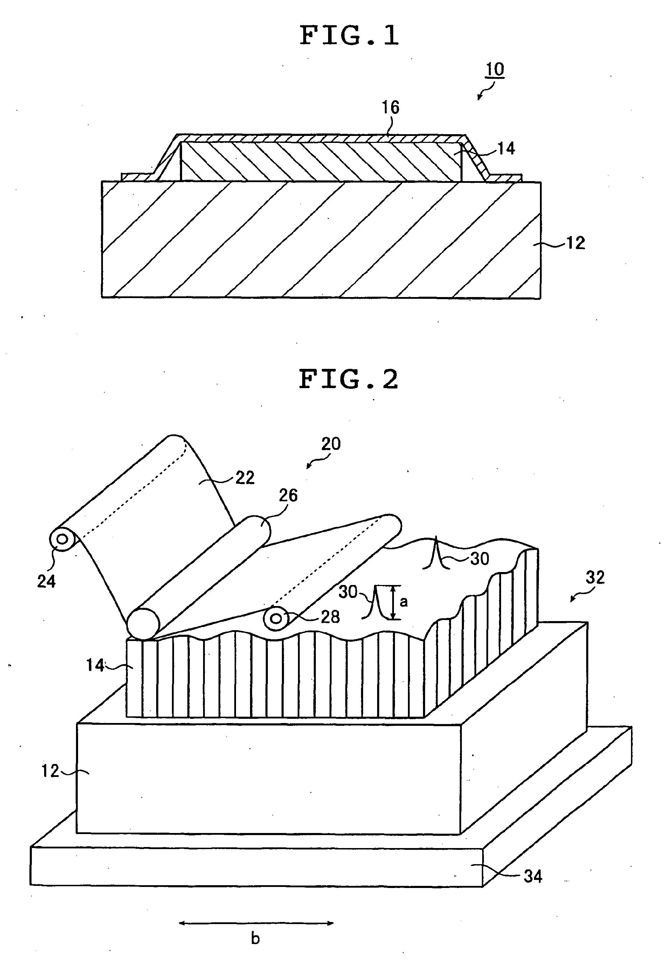

A first method of the present invention for producing a phosphor panel is described below in detail with reference to the accompanying drawings. FIG. 1 is a cross sectional view showing the structure of an embodiment of a stimulable phosphor panel produced by the inventive production method.

As shown in FIG. 1, a phosphor panel 10 produced by the inventive production method includes at least a substrate 12, a stimulable phosphor layer (hereinafter referred to as a phosphor layer) 14 formed on the substrate 12 by vacuum film deposition and a moisture-proof protective layer 16 with which the phosphor layer 14 is sealed to prevent the phosphor layer 14 from absorbing moisture.

There is no particular limitation on the substrate 12 in the first method of the present invention for producing a phosphor panel and various types as commonly used in phosphor panels are usable.

Exemplary types include plastic films such as cellulose acetate film, polyester film, polyethylene terephthalate film, polyamide film, polyimide film, triacetate film, and polycarbonate film; glass plates made of quartz glass, alkali-free glass, soda glass, heat-resistant glass (e.g., Pyrex™) and the like; metal sheets such as aluminum sheet, iron sheet, copper sheet and chromium sheet; and sheets obtained by forming a coating layer such as a metal oxide layer on the surfaces of such metal sheets.

In the first method of the present invention for producing a phosphor panel, the phosphor layer 14 is formed by vacuum film deposition on the surface of the substrate 12 as described above.

In the present invention, the substrate 12 may be composed of only the film or sheet described above. Alternatively, the substrate 12 may be the one obtained by forming on the surface of such film or sheet, a reflective film for reflecting photostimulated luminescence thereon, and further forming on the reflective film a barrier film for protecting the reflective film.

In the present invention, there is no particular limitation on the step prior to forming the phosphor layer 14 and the step as described above can be applied. For example, the phosphor layer 14 may be formed on the surface of the substrate 12 obtained by forming a reflective film for reflecting photostimulated luminescence on the surface of the substrate 12 and further a barrier film for protecting the reflective film thereon. Further, the phosphor layer 14 is preferably a columnar phosphor layer.

Various materials can be used for the stimulable phosphor constituting the phosphor layer 14 and preferred examples are given below.

Stimulable phosphors disclosed in US 3,859,527 are "SrS:Ce, Sm", "SrS:Eu, Sm", "ThO₂:Er", and "La₂O₂S:Eu, Sm".

JP 55-12142 A discloses "ZnS:Cu, Pb", "BaO·xAl₂O₃:Eu (0.8 ≤ x ≤ 10)", and stimulable phosphors represented by the general formula "M^{II}O·xSiO₂:A". In this formula, M^{II} is at least one element selected from the group consisting of Mg, Ca, Sr, Zn, Cd, and Ba, A is at least one element selected from the group consisting of Ce, Tb, Eu, Tm, Pb, Tl, Bi, and Mn, and 0.5 ≤ x ≤ 2.5.

Stimulable phosphors represented by the general formula "LnOX:xA" are disclosed by JP 55-12144 A. In this formula, Ln is at least one element selected from the group consisting of La, Y, Gd, and Lu, X is at least one element selected from Cl and Br, A is at least one element selected from Ce and Tb, and 0 ≤ x ≤ 0.1.

Stimulable phosphors represented by the general formula " (Ba₁₋ₓ, M²⁺ₓ)FX:yA" are disclosed by JP 55-12145 A. In this formula, M²⁺ is at least one element selected from the group consisting of Mg, Ca, Sr, Zn, and Cd, X is at least one element selected from Cl, Br, and I, A is at least one element selected from Eu, Tb, Ce, Tm, Dy, Pr, Ho, Nd, Yb, and Er, 0 ≤ x ≤ 0.6, and 0 ≤ y ≤ 0.2.

JP 59-38278 A discloses stimulable phosphors represented by the general formula "xM₃(PO₄)₂·NX₂:yA" or "M₃(PO₄)₂·yA". In this formula, M and N are each at least one element selected from the group consisting of Mg, Ca, Sr, Ba, Zn, and Cd, X is at least one element selected from F, Cl, Br, and I, A is at least one element selected from Eu, Tb, Ce, Tm, Dy, Pr, Ho, Nd, Yb, Er, Sb, Tl, Mn, and Sn, 0 ≤ x ≤ 6, and 0 ≤ y ≤ 1.

Stimulable phosphors are represented by the general formula "nReX₃·mAX'₂:xEu" or "nReX₃·mAX'₂:xEu, ySm". In this formula, Re is at least one element selected from the group consisting of La, Gd, Y, and Lu, A is at least one element selected from Ba, Sr, and Ca, X and X' are each at least one element selected from F, Cl, and Br, 1 × 10⁻⁴ < x < 3 × 10⁻¹, 1 × 10⁻⁴ < y < 1 × 10⁻¹, and 1 × 10⁻³ < n/m < 7 × 10⁻¹.

Alkali halide-based stimulable phosphors represented by the general formula "M^{I}X·aM^{II}X'₂·bM^{III}X"₃:cA" are disclosed by JP 61-72087 A. In this formula, M^{I} represents at least one element selected from the group consisting of Li, Na, K, Rb, and Cs. M^{II} represents at least one divalent metal selected from the group consisting of Be, Mg, Ca, Sr, Ba, Zn, Cd, Cu, and Ni. M^{III} represents at least one trivalent metal selected from the group consisting of Sc, Y, La, Ce, Pr, Nd, Pm, Sm, Eu, Gd, Tb, Dy, Ho, Er, Tm, Yb, Lu, Al, Ga, and In. X, X', and X" each represent at least one element selected from the group consisting of F, Cl, Br, and I. A represents at least one element selected from the group consisting of Eu, Tb, Ce, Tm, Dy, Pr, Ho, Nd, Yb, Er, Gd, Lu, Sm, Y, Tl, Na, Ag, Cu, Bi, and Mg, 0 ≤ a < 0.5, 0 ≤ b < 0.5, and 0 ≤ c < 0.2.

Stimulable phosphors represented by the general formula "(Ba₁₋ₓ, M^{II}ₓ)F₂·aBaX₂:yEu, zA" are disclosed by JP 56-116777 A. In this formula, M^{II} is at least one element selected from the group consisting of Be, Mg, Ca, Sr, Zn, and Cd, X is at least one element selected from Cl, Br, and I, A is at least one element selected from Zr and Sc, 0.5 ≤ a ≤ 1.25, 0 ≤ x ≤ 1, 1 × 10⁻⁶ ≤ y ≤ 2 × 10⁻¹ and 0 < z ≤ 1 × 10⁻².

Stimulable phosphors represented by the general formula "M^{III}OX:xCe" are disclosed by JP 58-69281 A. In this formula, M^{III} is at least one trivalent metal selected from the group consisting of Pr, Nd, Pm, Sm, Eu, Tb, Dy, Ho, Er, Tm, Yb, and Bi, X is at least one element selected from Cl and Br, and 0 ≤ x ≤ 0.1.

Stimulable phosphors represented by the general formula "Ba₁₋ₓMₐLₐFX: yEu²⁺" are disclosed by JP 58-206678 A. In this formula, M is at least one element selected from the group consisting of Li, Na, K, Rb, and Cs, L is at least one trivalent metal selected from the group consisting of Sc, Y, La, Ce, Pr, Nd, Pm, Sm, Gd, Tb, Dy, Ho, Er, Tm, Yb, Lu, Al, Ga, In, and Tl, X is at least one element selected from Cl, Br, and I, 1 × 10⁻² ≤ x ≤ 0.5, 0 ≤ y ≤ 0.1, and a is x/2.

Stimulable phosphors represented by the general formula "M^{II}FX·aM^{I}X'·bM'^{II}X"₂·cM^{III}X₃·xA:yEu²⁺" are disclosed by JP 59-75200 A. In this formula, M^{II} is at least one element selected from the group consisting of Ba, Sr, and Ca, M^{I} is at least one element selected from Li, Na, K, Rb, and Cs, M'^{II} is at least one divalent metal selected from Be and Mg, M^{III} is at least one trivalent metal selected from the group consisting of Al, Ga, In, and Tl, A is a metal oxide, X, X', and X" are each at least one element selected from the group consisting of F, Cl, Br, and I, 0 ≤ a ≤ 2, 0 ≤ b ≤ 1 × 10⁻², 0 ≤ c ≤ 1 × 10⁻², and a + b + c ≥ 10⁻⁶, 0 < x ≤ 0.5, and 0 < y ≤ 0.2.

Alkali halide-based stimulable phosphors disclosed by JP 61-72087 A are preferred because they have excellent photostimulated luminescence characteristics and the effect of the present invention is advantageously obtained. Alkali halide-based stimulable phosphors in which M^{I} contains at least Cs, X contains at least Br, and A is Eu or Bi are more preferred, and stimulable phosphors represented by the general formula "CsBr:Eu" are most preferred.

There is no particular limitation on the method of forming the phosphor layer 14 made of such a stimulable phosphor and various vacuum film deposition techniques such as vacuum deposition, sputtering and CVD (chemical vapor deposition) can be employed.

Among others, vacuum deposition is preferable in consideration of productivity or the like. Multi-source vacuum deposition in which a material for a phosphor component and a material for an activator component are separately evaporated under heating is more preferable. For example, the phosphor layer 14 of "CsBr:Eu" is preferably formed by multi-source vacuum deposition in which cesium bromide (CsBr) as the material for the phosphor component and europium bromide (EuBrₓ (x is generally 2 to 3)) as the material for the activator component are separately evaporated under heating.

There is no particular limitation on the heating method used in vacuum deposition. For example, the phosphor layer 14 may be formed through electron beam heating employing an electron gun or the like, or through resistance heating. When the phosphor layer 14 is formed through multi-source vacuum deposition, all materials may be evaporated under heating by the same heating means (such as electron beam heating). Alternatively, the material for the phosphor component may be evaporated under heating through electron beam heating, and the material for the activator component, which is in a trace amount, may be evaporated under heating through resistance heating.

There is also no particular limitation on the conditions under which the phosphor layer 14 is formed through deposition, and the conditions are determined as appropriate in accordance with the film deposition method used, the composition of the phosphor layer 14 to be formed and other factors. For example, in the case of vacuum deposition, film deposition is preferably carried out at a degree of vacuum of 1 × 10⁻⁵ Pa to 1 × 10⁻² Pa and a deposition rate of 0.05 µm/min to 300 µm/min. In the case of multi-source vacuum deposition, the evaporation rates of both the materials are controlled so that the ratio of the matrix component content to the activator component content falls within a desired range.

According to the study made by the inventor of the present invention, when any of the various stimulable phosphors described above, particularly an alkali halide-based stimulable phosphor, and more particularly a phosphor represented by "CsBr:Eu" is deposited in vacuo to form the phosphor layer 14, film deposition is preferably carried out by evacuating once a system to a high degree of vacuum; and introducing argon gas, nitrogen gas, or the like into the system to adjust the internal pressure to a degree of vacuum of about 0.1 Pa to 2 Pa and particularly about 0.5 Pa to 1.5 Pa (this degree of vacuum is hereinafter referred to as medium vacuum).

The phosphor layer 14 formed may be heated at 50°C to 400°C during film deposition through heating of the substrate or the like.

The phosphor layer 14 may be formed by a method commonly used in the art in which the layer is formed as the substrate rotates (more specifically, rotates on its axis or around some other element, or both on its axis and around some other element). However, the phosphor layer 14 is preferably formed by arranging evaporation sources in one direction and linearly transporting the substrate in a direction perpendicular to the direction in which the evaporation sources are arranged, more preferably by linearly and reciprocally transporting the substrate several times. Use of such a forming method allows the phosphor layer 14 formed to have a more uniform thickness.

There is also no particular limitation on the thickness of the phosphor layer 14 formed. However, the phosphor layer 14 preferably has a thickness of 10 to 1,000 µm and more preferably 20 to 800 µm.

In an embodiment of the first method of the present invention for producing a phosphor panel, a vacuum deposition device that carries out vacuum deposition as the substrate 12 is being linearly transported is employed to form the phosphor layer 14 on the substrate 12.

In the first method of the present invention for producing a phosphor panel, the thus formed phosphor layer 14 is subjected to heat treatment (annealing) to have excellent photostimulated luminescence characteristics.

Heat treatment as used herein refers to a treatment that includes at least one of the state in which the phosphor layer 14 formed is kept at a temperature of 100 °C or higher and the state in which the temperature of the phosphor layer 14 formed is increased or decreased at a rate exceeding 10°C/min.

The phosphor layer 14 can be heat-treated by any known method such as a method employing a firing furnace. Heat treatment can also be carried out by employing any vacuum deposition device that has a means for heating the substrate 12.

There is no particular limitation on the conditions under which the phosphor layer 14 is heat-treated. For example, heat treatment is preferably carried out under an inert atmosphere such as a nitrogen atmosphere at 50°C to 600°C (particularly 100°C to 300°C) for 10 minutes to 10 hours (particularly 30 minutes to 3 hours).

In the first method of the present invention for producing a phosphor panel, after the phosphor layer 14 has been heat-treated, the surface of the phosphor layer 14 is polished to effectively eliminate hillocks 30 (see FIG. 2) occurring on the surface of the phosphor layer 14.

In the first method of the present invention for producing a phosphor panel, the polishing treatment on the surface of the phosphor layer is carried out as follows: A thickness profile of the phosphor layer is estimated and the surface of the phosphor layer is polished by means of a polishing member as it is pressed with a pressing member that extends in a one-dimensional direction in such a way that the direction in which the thickness profile of the phosphor layer 14 is more uniform coincides with the direction in which the pressing member extends (namely, its rotational axis direction), with the phosphor layer and the polishing member being moved relative to each other in a direction perpendicular to the direction in which the pressing member extends.

Now referring to FIG. 2, an exemplary step of polishing the surface of the phosphor layer 14 in the first method of the present invention for producing a phosphor panel is described below in detail. FIG. 2 is a view illustrating the step of polishing the phosphor layer in the first method of the present invention for producing a phosphor panel.

A polishing apparatus indicated by 20 in FIG. 2 comprises a feed section 24 for feeding a web of lapping tape 22, a pressing roll 26 as a pressing member which brings the lapping tape 22 into contact with the phosphor layer 14 as the former is positioned with respect to the latter, and a take-up section 28 for winding up the tape 22. The polishing apparatus 20 is so adapted that it is moved in its entirety by a moving mechanism (not shown) in the direction of a two-headed arrow b (in the polishing direction).

In the case under consideration, the surface of the phosphor layer 14 is polished by means of the lapping tape 22 in web form of a specified width which is conveyed by a feed/take-up drive mechanism.

The polishing step depicted in FIG. 2 is described below more specifically. The polishing apparatus 20 used in this step is so designed that the surface of the phosphor layer 14 formed on the substrate 12 is polished by means of the lapping tape 22 in web form as it is pressed under the pressing roll 26 while it is conveyed in a longitudinal direction, whereby the phosphor layer 14 and the lapping tape 22 are moved relative to each other as they are driven in mutual contact, and a phosphor sheet 32 is moved in a direction opposite to the transport direction of the lapping tape 22.

In the first method of the present invention for producing a phosphor panel, the pressing roll 26 is used as the pressing member but this is not the sole case of the present invention and otherwise shaped members may be employed, such as a cylindrical contact roll and a pad in the form of a quadrangular prism. There is also no particular limitation on the length of the pressing roll 26 as measured along its axis of rotation; however, in order to ensure efficient and uniform polishing, the axial length of the pressing roll 26 is preferably greater than the size of the phosphor layer 14 as measured in the direction in which the pressing roll 26 extends.

The polishing apparatus 20 may be moved by various known mechanisms, including a rack-and-pinion mechanism and a ball screw mechanism, that can transform the rotation of a motor and other drive sources. The polishing apparatus 20 may be moved in one direction, or reciprocally with the direction of movement being changed periodically. In the latter case, the rate (frequency) of changing the direction of movement may be determined as appropriate.

As for the speed at which the phosphor sheet 32 and the lapping tape 22 are moved relative to each other (the contact speed of the polishing member) may be determined as appropriate for the characteristics of the phosphor layer and those of the polishing member; in the embodiment under consideration, the phosphor layer (CsBr:Eu) is relatively soft and a sufficiently high polishing speed can be attained even if the speed of relative movement is low.

On the following pages, the procedure of polishing the phosphor layer 14 with the polishing apparatus 20 is described in detail.

The phosphor sheet 32 having the phosphor layer 14 deposited on the substrate 12 is then subjected to the step of polishing with the polishing apparatus 20.

To set the phosphor sheet 32, it may be brought into engagement with a sheet support table 34 by means of a known engaging member. As a preliminary step, a thickness profile of the phosphor layer 14 is estimated and then the phosphor sheet 32 is set on the sheet support table 34 in such a way that the direction in which the thickness profile of the phosphor layer 14 is more uniform is parallel to the axis of rotation of the pressing roll 26.

The thickness profile of the phosphor layer 14 may be estimated by preliminary measurement with an external instrument such as a film thickness gage. Alternatively, if a film deposition method of interest is such that an approximate thickness profile can be derived from it, one may adopt that data as such. Take, for example, a method in which evaporation sources are arranged in one direction and a film is deposited on the substrate 12 as it is transported linearly (reciprocally) in a direction perpendicular to the linear array of evaporation sources. Because of the inherent nature of this method, a wavy profile usually occurs to the phosphor layer 14 in a direction perpendicular to the transport of the substrate 12 and eventually the thickness profile of the phosphor layer 14 becomes less uniform in that direction than in the direction in which the substrate 12 is transported. Consequently, if the method under consideration is employed to deposit the phosphor layer 14, one does not need to measure its thickness profile in order to determine the direction in which the substrate 12 should be transported but may simply set the phosphor sheet 32 on the sheet support table 34 in such a way that the direction in which the thickness profile of the phosphor layer 14 is more uniform, namely, the direction in which the substrate 12 is transported during film deposition is parallel to the axis of rotation of the pressing roll 26.

In the next step, the polishing apparatus 20 is adjusted in position so that it registers with a predetermined POLISH START position on the surface of the phosphor layer 14 and it is then set to provide the required amount of polishing. This positional adjustment may be performed by any suitable method such as placing the polishing apparatus 20 on guide rails provided in preset positions.

When the setting of the phosphor sheet 32 and the positioning of the polishing apparatus 20 have been completed, one starts to feed the lapping tape 22 in the polishing apparatus 20 and then actuates the moving (reciprocating) mechanism (not shown) so that the polishing apparatus 20 is driven from the state shown in FIG. 2 to the right (of the arrow b) while the pressing roll 26 is pressed against the lapping tape 22, whereupon the surface of the lapping tape 22 contacts the surface of the phosphor layer 14 in the phosphor sheet 32 and starts to polish the phosphor layer 14. Usually, the polishing step ends at the point in time when the polishing apparatus 20 has passed over the phosphor sheet 32.

It should also be noted that when the setting of the phosphor sheet 32 and the positioning of the polishing apparatus 20 have been completed, the feed of the lapping tape 22 from the feed section 24 and its wind-up by the take-up section 28 may be repeated to perform polishing; alternatively, the substrate 12 may be driven to perform polishing.

The roughness of the lapping tape 22 used to perform surface polishing and the duration of time for which the phosphor sheet 32 is polished using that tape may be determined by preliminary empirical measurement.

Other parameters such as the frequency at which the lapping tape 22 is repeatedly used may also be determined empirically to some extent.

In the first method of the present invention for producing a phosphor panel, a thickness profile of the phosphor layer 14 is first estimated and the surface of the phosphor layer 14 is then polished by means of the lapping tape 22 as it is pressed under the pressing roller 26 which extends in a one-dimensional direction in such a way that the direction in which the thickness profile of the phosphor layer 14 is more uniform coincides with the direction in which the pressing roll 16 extends (namely, its rotational axis direction), with the phosphor layer 14 and the lapping tape 22 pressed under the pressing roller 26 being moved relative to each other in a direction perpendicular to the axis of rotation of the pressing roll 26. As a result, the lapping tape 22 can trace the wavy surface of the phosphor layer 14 as it is pressed under the pressing roller 26, whereby delamination of the lapping tape 22 from the phosphor layer 14 on account of its greater deviation from uniformity in thickness profile such as waviness can be effectively prevented to ensure that the lapping tape 22 is positively pressed against the entire surface of the phosphor layer 14. Consequently, any hillocks 30 that have been formed on the surface of the phosphor layer 14 can also be positively polished away, no matter how small they are. Since it becomes possible to effectively polish away the hillocks 30, the chance of polishing away any other portions than the hillocks 30 is sufficiently decreased to reduce the amount by which the phosphor layer 14 needs to be polished; further in addition, this will reduce the chance for the polishing debris to get stuck between adjacent columnar crystals in the phosphor layer 14, thereby lowering the chance of deterioration in the quality of the radiation image to be formed on the phosphor panel.

Furthermore, according to the study made by the inventor of the present invention, in order that image defects due to the hillocks 30 are prevented more effectively, their height a is preferably controlled to 10 µm or less; in addition, as already mentioned, if the moisture-proof protective layer 16 is lifted by a hillock 30 to assume a tent-like shape, image deterioration is also likely to occur; in order to prevent this problem more positively, the hillock's height a is preferably controlled to 2 µm or less. With the conventional known method of polishing the surface of the phosphor layer 14, it has been impossible to fabricate a phosphor panel having the phosphor layer 14 with hillocks 30 whose height a is preferably 10 µm or less, more preferably 2 µm or less. However, according to the first method of the present invention, the phosphor panel 10 having the phosphor layer 14 with hillocks 30 whose height a is preferably 10 µm or less, more preferably 2 µm or less, can be fabricated in an advantageous way.

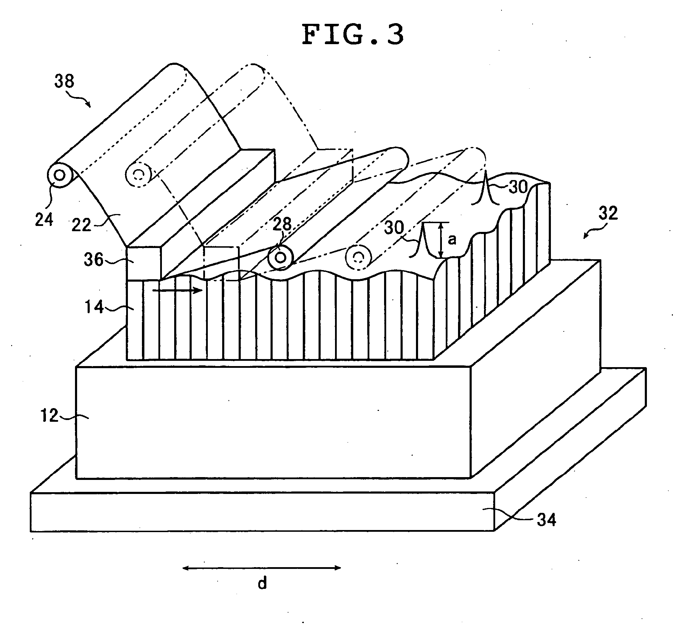

Now, the step of polishing the surface of the phosphor layer 14 in the second method of the present invention for producing a phosphor panel is described in detail with reference to FIG. 3 which illustrates how the phosphor layer is polished according to the present invention by a different method than what is shown in FIG. 2.

The second method of the present invention for producing a phosphor panel can be implemented in basically the same manner as the first method, except for the step described below of polishing the phosphor layer 14. Hence, the following description only concerns that portion of the step of polishing the phosphor layer 14 which differs from the first method of the present invention for producing a phosphor panel.

Like the first method of the present invention for producing a phosphor panel, the second method starts with forming the phosphor layer 14 on the substrate 12, then performs heat treatment, and polishes the surface of the phosphor layer 14.

In the second method of the present invention for producing a phosphor panel, the surface of the phosphor layer 14 is polished repeatedly by means of the lapping sheet 22 as a polishing member in changed polishing positions on the phosphor layer 14, with the phosphor layer 14 and the lapping tape 22 being moved relative to each other at a distance of from 50 µm to 400 µm, preferably between 100 µm and 300 µm. There are no particular limitations other than polishing the surface of the phosphor layer 14.

The polishing apparatus generally indicated by 38 in FIG. 3 only differs from the polishing apparatus 20 of FIG. 2 in that a pad 36 in the form of a quadrangular prism is used as a pressing member, and all other members that are the same as those used in the polishing apparatus 20 are identified by like numerals.

In the polishing apparatus 38, the pad 36 presses the lapping sheet 22 against the phosphor layer 14 and by reciprocating the whole of the polishing apparatus 38 in directions perpendicular to the direction in which the pad 36 extends or by reciprocating the phosphor sheet 32 in the same directions, the phosphor layer 14 and the lapping tape 22 are moved relative to each other for polishing the phosphor layer 14.

In the polishing apparatus 38 which is used in the second method of the present invention for producing a phosphor panel, the distance at which the phosphor layer 14 and the lapping tape 22 are moved relative to each other in one polishing cycle is controlled to lie between 50 µm and 400 µm, preferably between 100 µm and 300 µm. As shown conceptually in FIG. 3 by chain double-dashed lines, this polishing procedure is repeated several times in changed polishing positions on the phosphor layer 14, whereby its entire surface is polished. For every polishing cycle or after each passage of a predetermined number of polishing cycles with the distance of relative movement adjusted to lie between 50 µm and 400 µm, preferably between 100 µm and 300 µm, the lapping tape 22 is transported from the feed section 24 to the take-up section 28 so that a new supply of the lapping tape 22 is used for polishing the phosphor layer 14.

The pad 36 in the form of a quadrangular prism may be mentioned as an advantageous example of the pressing member to be used in the polishing apparatus 38; various other pressing members can of course be employed, as exemplified by one having a sufficiently larger area than the phosphor layer 14 to ensure that its surface can be polished in one action, and the pressing roll used in the polishing apparatus 20. There is also no particular limitation on the length of the pressing member as measured in the direction in which it extends; however, in order to ensure efficient and uniform polishing, the length of the pressing member is preferably greater than the width of the phosphor layer 14 as measured in a direction parallel to the direction in which the pad 36 extends.

The mechanism for causing the phosphor layer 14 and the lapping tape 22 to move relative to each other in the polishing apparatus 38 may be selected from among various known types, including a rack-and-pinion mechanism and a ball screw mechanism. The moving mechanism for changing the polishing position on the phosphor layer 14 may be the same as above or, alternatively, it may be any other known mechanism. It should be noted here that the mechanism for effecting relative movement and the moving mechanism for changing the polishing position may be the same or different.

As for the speed at which the phosphor sheet 32 and the lapping tape 22 are moved relative to each other (the contact speed of the polishing member) may be determined as appropriate for the characteristics of the phosphor layer and those of the polishing member; in the embodiment under consideration, the phosphor layer (CsBr:Eu) is relatively soft and a sufficiently high polishing speed can be attained even if the speed of relative movement is low.

On the following pages, the procedure of polishing the phosphor layer with the polishing apparatus 38 is described in detail.

The phosphor sheet 32 which has the phosphor layer 14 deposited on the substrate 12 by the same procedure as in the first method of the present invention for producing a phosphor panel is then subjected to the step of polishing with the polishing apparatus 38.

To set the phosphor sheet 32, it may be brought into engagement with the sheet support table 34 by means of a known engaging member. Like the first method of the present invention for producing a phosphor panel, the second method is preferably such that the phosphor sheet 32 is set on the sheet support table 34 in such a way that the direction in which the pad 36 in the form of a quadrangular prism in the polishing apparatus 38 extends is parallel to the direction in which the thickness profile of the phosphor layer 14 is more uniform.

First, the polishing apparatus 38 is adjusted in position so that it registers with a predetermined POLISH START position on the surface of the phosphor layer 14 and it is then set to provide the required amount of polishing. This positional adjustment may be performed by any suitable method such as placing the polishing apparatus 38 on guide rails provided in preset positions.

When the setting of the phosphor sheet 32 and the positioning of the polishing apparatus 38 have been completed, one starts to feed the lapping tape 22 in the polishing apparatus 38 and then actuates the moving (reciprocating) mechanism (not shown) so that the polishing apparatus 38 is driven from the state shown in FIG. 3 to the right (of an arrow d) while the pad 36 is pressed against the lapping tape 22, whereupon the surface of the lapping tape 22 contacts the surface of the phosphor layer 14 in the phosphor sheet 32 and starts to polish the phosphor layer 14. In this case, the polishing is repeated several times in changed polishing positions on the phosphor layer 14, with the phosphor layer 14 and the lapping tape 22 being moved relative to each other at a distance of from 50 µm to 400 µm, preferably between 100 µm and 300 µm, whereby the surface of the phosphor layer 14 is polished. Usually, the polishing step ends at the point in time when the polishing apparatus 38 has passed over the phosphor sheet 32.

The roughness of the lapping tape 22 used to perform surface polishing and the duration of time for which the phosphor sheet 32 is polished using that tape may be determined by preliminary empirical measurement.

Other parameters such as the frequency at which the lapping tape 22 is repeatedly used may also be determined empirically to some extent.

In the second method of the present invention for producing a phosphor panel, the polishing is repeated several times in changed polishing positions on the phosphor layer 14 as the phosphor layer 14 and the lapping tape 22 as a polishing member are moved relative to each other at a distance of from 50 µm to 400 µm.

In this case, the distance at which the phosphor layer 14 and the lapping tape 22 as a polishing member are moved relative to each other is preferably great enough to ensure that the height of hillocks is lowered with rapidity. On the other hand, as the phosphor layer 14 is progressively polished by its relative movement with respect to the lapping tape 22, flaws may accordingly develop in amounts that depend on the distance of the relative movement. The flaws are not serious enough to render the fabricated phosphor panel.irreparably unsuitable for use but they must be manipulated by an image correcting scheme that is commonly employed in radiation image reading apparatuses. In other words, by repeating the polishing step several times in changed polishing positions on the phosphor layer 14 as the phosphor layer 14 and the lapping tape 22 as a polishing member are moved relative to each other at a distance of from 50 µm to 400 µm, the two requirements, one for increasing the speed of the polishing step and the other for minimizing the load of the image correcting scheme, can be met efficiently so that the polishing is performed with high efficiency while, at the same time, the flaws that develop from the polishing step are just long enough to cause noise at comparable levels to the noise from the phosphor panel 10 but they are by no means longer than that and can be erased together with the noise by performing subsequent image processing on the phosphor panel 10. Hence, the fabricated phosphor panel has satisfactory graininess.

In the second method of the present invention for producing a phosphor panel, it is preferred that the polishing be repeated several times in changed polishing positions on the phosphor layer 14 as the phosphor layer 14 and the lapping tape 22 as a polishing member are moved relative to each other at a distance of from 100 µm to 300 µm.

As mentioned above, the distance at which the phosphor layer 14 and the lapping tape 22 as a polishing member are moved relative to each other is preferably great enough to ensure that the height a of hillocks 30 is lowered with rapidity. On the other hand, as the phosphor layer 14 is progressively polished by its relative movement with respect to the lapping tape 22, flaws may accordingly develop in amounts that depend on the distance of the relative movement. The flaws are not serious enough to render the fabricated phosphor panel irreparably unsuitable for use but they must be manipulated by an image correcting scheme that is commonly employed in radiation image reading apparatuses. Many of the currently used radiation image reading apparatuses set 100 µm as the unit size of one reading pixel and if any abnormal pixel occurs, it is necessary to correct a square region that is created by adding one pixel to the abnormal pixel. If the distance of the relative movement is 100 µm, a square region equivalent to (1+1)² = 4 pixels must be corrected; if the distance of the relative movement is 200 µm, a square region equivalent to (2+1)² = 9 pixels must be corrected; and if the distance of the relative movement is 300 µm, a square region equivalent to (3+1)² = 16 pixels must be corrected; the greater the number of pixels that need to be corrected, the longer time is required to effect correction.

Therefore, the present inventor tried to compromise the time required to lower the height of hillocks 30 against the time required to erase the polishing-associated flaws in the step of correcting the radiation image being read from the phosphor panel 10; as a result of the intensive studies made to attain that object, the inventor found that an optimum distance at which the phosphor layer 14 and the lapping tape 22 as a polishing member should be moved relative to each other in the process of fabricating the phosphor panel 10 was between 100 µm and 300 µm.

As already mentioned, the pressing member that can be used in the second method of the present invention for producing a phosphor panel is by no means limited to the type that extends in a one-dimensional direction as exemplified by the pad 36 in the form of a quadrangular prism and it is also possible to use a pressing member so shaped as to cover the entire surface of the phosphor layer 14. Nevertheless, in the second method of the present invention for producing a phosphor panel, it is particularly preferred that the surface of the phosphor layer 14 be polished by means of the lapping tape 22 as it is pressed with a pressing member that extends in a one-dimensional direction in such a way that the direction in which the pressing member extends is parallel to the direction in which the thickness profile of the phosphor layer 14 is more uniform, and the phosphor layer 14 and the lapping tape 22 being moved relative to each other in a direction perpendicular to the direction in which the pressing member extends. The reason is as follows: in the second method, like the first method of the present invention for producing a phosphor panel, the lapping tape 22 can trace the wavy surface of the phosphor layer 14 as it is pressed under the pad 36 in the form of a quadrangular prism, whereby delamination of the lapping tape 22 from the phosphor layer 14 on account of its greater deviation from uniformity in thickness profile such as waviness can be effectively prevented to ensure that the lapping tape 22 is positively pressed against the entire surface of the phosphor layer 14. Consequently, any hillocks 30 that have been formed on the surface of the phosphor layer 14 can also be positively polished away, no matter how small they are. As a consequence, in the second method, too, a phosphor panel 10 having the phosphor layer 14 with hillocks 30 whose height a is reduced to 10 µm or less in order that image defects due to the hillocks 30 are prevented, or a phosphor panel 10 having the phosphor layer 14 with hillocks 30 whose height a is reduced to 2 µm or less in order to effectively prevent any image quality deterioration that may occur if the moisture-proof protective layer 16 is lifted by a hillock 30 to assume a tent-like shape can be fabricated in an advantageous way.

As a further advantage of the second method of the present invention for producing a phosphor panel, the flaws that develop from the polishing step are just long enough to cause noise at comparable levels to the noise from the fabricated phosphor panel 10 but they are by no means longer than that and can be erased together with the noise by performing subsequent image processing on the phosphor panel 10. Hence, phosphor panels that produce very sharp radiation image can be fabricated in a consistent manner.

The phosphor layer 14 that has been thus formed by the first or second method of the present invention for producing a phosphor panel is highly hygroscopic and its characteristics readily deteriorate due to moisture absorption. Therefore, the phosphor layer 14 is sealed in an enclosed region between the moisture-proof protective layer 16 and the substrate 12 in order to prevent moisture absorption.

The moisture-proof protective layer 16 is not particularly limited as long as it has sufficient moisture resistance, and various types thereof can be used. For example, the moisture-proof protective layer 16 is formed of 3 layers on a polyethylene terephthalate (PET) film: an SiO₂ film; a hybrid layer of SiO₂ and polyvinyl alcohol (PVA); and an SiO₂ film. Other preferable examples of the moisture-proof protective layer 16 include: a glass plate (film); a film of resin such as polyethylene terephthalate or polycarbonate; and a film having an inorganic substance such as SiO₂, Al₂O₃, or SiC deposited on the resin film. For formation of the moisture-proof protective layer 16 having 3 layers of SiO₂ film/hybrid layer of SiO₂ and PVA/SiO₂ film on the PET film, the SiO₂ films may be formed through sputtering and the hybrid layer of SiO₂ and PVA may be formed through a sol-gel process, for example. The hybrid layer is preferably formed to have a ratio of PVA to SiO₂ of 1 : 1.

There is no particular limitation on the method of sealing the phosphor layer 14 with the moisture-proof protective layer 16. An exemplary method includes adhering the moisture-proof protective layer 16 to the surface of the substrate 12 with an adhesive. In the present invention, the moisture-proof protective layer 16 is only adhered to the surface of the substrate 12, but is preferably adhered to both the surface of the substrate 12 and the surface of the phosphor layer 14 as in the illustrated case in order to obtain the phosphor panel 10 having more excellent durability.

According to the first and second methods of the present invention for producing a phosphor panel, the height a of each of the hillocks 30 on the surface of the phosphor layer 14 can be reduced to 2 µm or less, so that the moisture-proof protective layer 16 is not considerably lifted by the hillocks 30 during the formation of the moisture-proof protective layer 16 on the phosphor layer 14, and the defective area is prevented from being enlarged due to such film lifting.

The method for producing the phosphor layer 10 has no particular limitation on the step after the phosphor layer 14 has been sealed.

## Claims

1. A method for producing a phosphor panel comprising the steps of:
forming a phosphor layer (14) by vacuum film deposition; and
polishing a surface of the phosphor layer (14) repeatedly by means of a polishing member (22) in changed polishing positions on the phosphor layer (14), with the phosphor layer (14) and the polishing member (22) being moved relative to each other in each polishing cycle,
wherein a relative moving range within which the phosphor layer (14) and the polishing member (22) are moved relatively each other along the surface of the phosphor layer (14) at each polishing position on the phosphor layer (14) is a distance of from 50 µm to 400 µm in each polishing cycle.

2. The method for producing a phosphor panel according to claim 1,
wherein the surface of the phosphor layer (14) is polished repeatedly by means of the polishing member (22) as it is pressed with a pressing member (26, 36) that extends in a one-dimensional direction in such a way that a direction in which a thickness profile of the phosphor layer (14) is more uniform coincides with the one-dimensional direction in which the pressing member (26, 36) extends, and the phosphor layer (14) and the polishing member (14) are moved relative to each other in a direction perpendicular to the one-dimensional direction in which the pressing member (26, 36) extends.

3. The method for producing a phosphor panel according to claim 2, further comprising the step of: estimating the thickness profile of the phosphor layer (14) before the surface of the phosphor layer is polished (14).

4. The method for producing a phosphor panel according to any one of claims 1 to 3, wherein the relative moving range within which the phosphor layer (14) and the polishing member (22) are moved relative to each other along the surface of the phosphor layer (14) at each polishing position on the phosphor layer (14) is between 100 µm and 300 µm in each polishing cycle.

5. The method for producing a phosphor panel according to any one of claims 1 to 4, wherein the phosphor layer (14) whose surface has been polished is sealed with a moisture-proof protective layer (16).

6. The method for producing a phosphor panel according to any one of claims 1 to 5, the phosphor layer (14) is formed of a stimulable phosphor.

7. The method for producing a phosphor panel according to any one of claims 1 to 6, the phosphor layer (14) is formed of CsBr:Eu.

## Patentansprüche

1. Verfahren zum Herstellen eines Leuchtstoffschirms, umfassend folgende Schritte:
Bilden einer Leuchtstoffschicht (14) durch Vakuumbeschichtung; und
wiederholtes Polieren einer Oberfläche der Leuchtstoffschicht (14) mittels eines Polierelements (22) an geänderten Polierstellen auf der Leuchtstoffschicht (14), wobei die Leuchtstoffschicht (14) und das Polierelement (22) relativ zueinander in jedem Polierzyklus bewegt werden,
wobei der Relativbewegungsbereich, innerhalb dessen die Leuchtstoffschicht (14) und das Polierelement (22) relativ zueinander entlang der Oberfläche der Leuchtstoffschicht an jeder Polierstelle der Leuchtstoffschicht (14) bewegt werden, eine Distanz von 50 µm bis 400 µm in jedem Polierzyklus ist.

2. Verfahren zum Herstellen eines Leuchtstoffschirms nach Anspruch 1,
wobei die Oberfläche der Leuchtstoffschicht (14) wiederholt mittels des Polierelements (22) poliert wird, während dieses mit einem Andrückteil (26, 36) angedrückt wird, welches sich in einer eindimensionalen Richtung in der Weise erstreckt, dass eine Richtung, in der ein Dickenprofil der Leuchtstoffschicht (14) mehr gleichmäßig ist, übereinstimmt mit der eindimensionalen Richtung, in der das Andrückteil (26, 36) sich erstreckt, und die Leuchtstoffschicht (14) und das Polierelement (14) relativ zueinander in einer Richtung rechtwinklig zu der eindimensionalen Richtung bewegt werden, in der sich das Andrückteil (26, 36) erstreckt.

3. Verfahren zum Herstellen eines Leuchtstoffschirms nach Anspruch 2, weiterhin umfassend den Schritt des Abschätzens des Dickenprofils der Leuchtstoffschicht (14), bevor die Oberfläche der Leuchtstoffschicht (14) poliert wird.

4. Verfahren zum Herstellen eines Leuchtstoffschirms nach einem der Ansprüche 1 bis 3, bei dem der Relativbewegungsbereich, innerhalb dessen die Leuchtstoffschicht (14) und das Polierelement (22) relativ zueinander entlang der Oberfläche der Leuchtstoffschicht (14) an jeder Polierstelle auf der Leuchtstoffschicht (14) bewegt werden, zwischen 100 µm und 300 µm bei jedem Polierzyklus beträgt.

5. Verfahren zum Herstellen eines Leuchtstoffschirms nach einem der Ansprüche 1 bis 4, bei dem die Leuchtstoffschicht (14), deren Oberfläche poliert wurde, mit einer feuchtigkeitsdichten Schutzschicht (16) versiegelt wird.

6. Verfahren zum Herstellen eines Leuchtstoffschirms nach einem der Ansprüche 1 bis 5, bei dem die Leuchtstoffschicht (14) aus einem anregbaren Leuchtstoff gebildet wird.

7. Verfahren zum Herstellen eines Leuchtstoffschirms nach einem der Ansprüche 1 bis 6, bei dem die Leuchtstoffschicht (14) aus CsBr:Eu gebildet wird.

## Revendications

1. Procédé de production d'un panneau phosphorescent comprenant les étapes consistant à :
former une couche phosphorescente (14) par dépôt d'un film sous vide ; et
polir une surface de la couche phosphorescente (14) de manière répétée au moyen d'un organe de polissage (22) dans des positions de polissage modifiées sur la couche phosphorescente (14), la couche phosphorescente (14) et l'organe de polissage (22) étant déplacés l'un par rapport à l'autre au cours de chaque cycle de polissage,
dans lequel un intervalle de déplacement relatif à l'intérieur duquel la couche phosphorescente (14) et l'organe de polissage (22) sont déplacés l'un par rapport à l'autre le long de la surface de la couche phosphorescente (14), dans chaque position de polissage sur la couche phosphorescente (14), est une distance de 50 µm à 400 µm au cours de chaque cycle de polissage.

2. Procédé de production d'un panneau phosphorescent selon la revendication 1,
dans lequel la surface de la couche phosphorescente (14) est polie de manière répétée au moyen de l'organe de polissage (22) qui est pressé par un organe presseur (26, 36) qui s'étend dans une direction monodimensionnelle, de telle sorte qu'une direction dans laquelle un profil d'épaisseur de la couche phosphorescente (14) est plus uniforme coïncide avec la direction monodimensionnelle dans laquelle l'organe presseur (26, 36) s'étend, et la couche phosphorescente (14) et l'organe de polissage (22) sont déplacés l'un par rapport à l'autre dans une direction perpendiculaire à la direction monodimensionnelle dans laquelle s'étend l'organe presseur (26, 36).

3. Procédé de production d'un panneau phosphorescent selon la revendication 2, comprenant de plus l'étape consistant à : estimer le profil d'épaisseur de la couche phosphorescente (14) avant que la surface de la couche phosphorescente (14) soit polie.

4. Procédé de production d'un panneau phosphorescent selon l'une quelconque des revendications 1 à 3, dans lequel l'intervalle de déplacement relatif à l'intérieur duquel la couche phosphorescente (14) et l'organe de polissage (22) sont déplacés l'un par rapport à l'autre le long de la surface de la couche phosphorescente (14) dans chaque position de polissage sur la couche phosphorescente (14) se situe entre 100 µm et 300 µm au cours de chaque cycle de polissage.

5. Procédé de production d'un panneau phosphorescent selon l'une quelconque des revendications 1 à 4, dans lequel la couche phosphorescente (14) dont la surface a été polie est scellée par une couche de protection (16) résistant à l'humidité.

6. Procédé de production d'un panneau phosphorescent selon l'une quelconque des revendications 1 à 5, dans lequel la couche phosphorescente (14) est formée d'une substance phosphorescente activable.

7. Procédé de production d'un panneau phosphorescent selon l'une quelconque des revendications 1 à 6, dans lequel la couche phosphorescente (14) est formée de CsBr:Eu.
